(19) **Europäisches Patentamt**
**European Patent Office**
**Office européen des brevets**

(11) **EP 4 346 351 A1**

(12) **EUROPEAN PATENT APPLICATION**
published in accordance with Art. 153(4) EPC

(43) Date of publication:
**03.04.2024 Bulletin 2024/14**

(51) International Patent Classification (IPC):
*H10K 59/00* (2023.01)

(21) Application number: **21969579.8**

(86) International application number:
**PCT/CN2021/143117**

(22) Date of filing: **30.12.2021**

(87) International publication number:
**WO 2023/123217 (06.07.2023 Gazette 2023/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **BOE Technology Group Co., Ltd.**
**Chaoyang District,**
**Beijing 100015 (CN)**
• **Chengdu BOE Optoelectronics Technology Co.,
Ltd.**
**Chengdu, Sichuan 611731 (CN)**

(72) Inventors:
• **ZHANG, Ruqin**
**Beijing 100176 (CN)**

• **KONG, Chao**
**Beijing 100176 (CN)**
• **QI, Yige**
**Beijing 100176 (CN)**
• **ZENG, Pingchuan**
**Beijing 100176 (CN)**
• **YANG, Feng**
**Beijing 100176 (CN)**
• **CHEN, Jing**
**Beijing 100176 (CN)**
• **ZOU, Hongyun**
**Beijing 100176 (CN)**

(74) Representative: **Brötz, Helmut et al
Rieder & Partner mbB
Patentanwälte - Rechtsanwalt
Yale-Allee 26
42329 Wuppertal (DE)**

(54) **DISPLAY SUBSTRATE AND DISPLAY APPARATUS**

(57) Embodiments of the present disclosure provide a display substrate and a display apparatus. The display substrate comprises: a base substrate; a pixel defining layer, the pixel defining layer being located on a side of the base substrate and having multiple pixel openings emitting different colors, a pixel opening having a pixel opening orthographic projection onto the base substrate; a black matrix, the black matrix being located on a side of the pixel defining layer distant from the base substrate, and comprising black matrix openings corresponding to the pixel openings, a black matrix opening having a black matrix opening orthographic projection onto the base substrate, the black matrix opening orthographic projection covering the corresponding pixel opening orthographic projection, and compared with the pixel opening, the black matrix opening having an opening extension. At the positions of at least two pixel openings emitting light of different colors, and in a direction parallel with the base substrate, the length of the opening extension is inversely proportional to the length of the pixel opening orthographic projection.

FIG. 4

**Description**

TECHNICAL FIELD

The present disclosure relates to the technical field of semiconductors, in particular to a display substrate and a display device.

BACKGROUND

Active-matrix organic light-emitting diode (AMOLED) is one of the most promising display technologies for its advantages of self-luminescence (there is no need of a backlight), simple structure, wide viewing angle, low power consumption and flexible display. Recently, with the continuous innovation and development of large-size and rollable organic light-emitting display screens, the requirement of low power consumption in the display field is also continuously raised. By increasing a transmittance of components above a light-emitting layer, it can effectively reduce an EL power consumption.

SUMMARY

The embodiments of the present disclosure provide a display substrate and a display device. The display substrate includes:

a base substrate;
a pixel defining layer, located at a side of the base substrate and having a plurality of pixel openings emitting light of different colors, wherein each of the plurality of pixel openings has a pixel opening orthographic projection on the base substrate; and
a black matrix, located at a side of the pixel defining layer away from the base substrate and including black matrix openings corresponding to the pixel openings, wherein each of the black matrix openings has a black matrix opening orthographic projection on the base substrate, the black matrix opening orthographic projection covers the corresponding pixel opening orthographic projection, and the black matrix opening has an opening expansion with relative to the pixel opening; at positions of at least two pixel openings with different light-emitting colors, in a same direction parallel to the base substrate, the opening expansion is inversely proportional to a length of the pixel opening orthographic projection.

In a possible implementation, the pixel opening orthographic projection is a polygon, and the pixel openings include a first pixel opening emitting light of a first color, the first pixel opening has a first side extending in a first direction, and a length of the first side of the first pixel opening is greater than or equal to lengths of remaining sides of the first pixel opening, and is greater than or equal to a longest side length of the pixel openings with other light-emitting colors; at the positions of the at least two pixel openings with different light-emitting colors, in a direction parallel to the base substrate and perpendicular to the first direction, the opening expansion is inversely proportional to the length of the pixel opening orthographic projection.

In a possible implementation, at the positions of the at least two pixel openings with different light-emitting colors, in the first direction parallel to the base substrate, the opening expansion is inversely proportional to the length of the pixel opening orthographic projection.

In a possible implementation, the first pixel opening is a red pixel opening emitting red light, and the pixel openings further include a blue pixel opening emitting blue light and a green pixel opening emitting green light;
one blue pixel opening, one red pixel opening and one green pixel opening are sequentially arranged along a direction perpendicular to the first direction to constitute one repeating unit, and a plurality of repeating units are sequentially arranged along the direction perpendicular to the first direction to form a pixel opening row.

In a possible implementation, the first pixel opening is a blue pixel opening emitting blue light, and the pixel openings further include a red pixel opening emitting red light and a green pixel opening emitting green light;
one red pixel opening, one green pixel opening and one blue pixel opening constitute one repeating unit, and in the repeating unit, the red pixel opening and the green pixel opening are arranged along the first direction, and a straight line passing through a center of the blue pixel opening and perpendicular to the first direction is located at a gap between the red pixel opening and the green pixel opening; a plurality of repeating units are sequentially arranged along the direction perpendicular to the first direction to form a pixel opening row.

In a possible implementation, the first pixel opening is a blue pixel opening emitting blue light, and the pixel openings further include a red pixel opening emitting red light, and a first green pixel opening and a second green pixel opening emitting green light;

one red pixel opening, one first green pixel opening, one second green pixel opening and one blue pixel opening constitute one repeating unit, and in the repeating unit, a center of the red pixel opening, a center of the blue pixel opening, a center of the first green pixel opening and a center of the second green pixel opening form a quadrilateral, two sides of the quadrilateral are parallel to the first direction, and the other two sides are perpendicular to the first direction; a connecting line between the center of the red pixel opening and the center of the blue pixel opening forms a first diagonal line of the quadrilateral, and the repeating units are arranged in sequence along a direction parallel to the first diagonal line to form a pixel opening row.

In a possible implementation, the pixel opening orthographic projection on the base substrate is circular, and the pixel openings include a blue pixel opening emitting blue light, a red pixel opening emitting red light, and a first green pixel opening and a second green pixel opening emitting green light;

one red pixel opening, one first green pixel opening, one second green pixel opening and one blue pixel opening constitute one repeating unit, and in the repeating unit, a center of the red pixel opening, a center of the blue pixel opening, a center of the first green pixel opening and a center of the second green pixel opening form a quadrilateral, and a connecting line between the center of the red pixel opening and the center of the blue pixel opening forms a first diagonal line of the quadrilateral, and the repeating units are arranged in sequence along a direction parallel to the first diagonal line to form a pixel opening row.

In a possible implementation, in the same direction parallel to the base substrate, a ratio of opening expansions of at least two pixel openings with different light-emitting colors is approximately inversely proportional to a ratio of lengths of orthographic projections of the corresponding pixel openings with different light-emitting colors on the base substrate.

In a possible implementation, the opening expansion is in the range from 2 nm to 10 nm.

In a possible implementation, the display substrate further includes a light-emitting part located at the pixel opening, and a color film layer located at a side of the black matrix away from the pixel defining layer; wherein the color film layer includes a color resistance located at the black matrix opening;

a peak wavelength of a transmission spectrum of the color resistance is blue-shifted with relative to a peak wavelength of an emission spectrum of the corresponding light-emitting part.

In a possible implementation, the peak wavelength of the transmission spectrum of the color resistor is blue-shifted by 10 nm to 15 nm with relative to the peak wavelength of the emission spectrum of the corresponding light-emitting part.

In a possible implementation, blue-shifted lengths of the peak wavelengths of the transmission spectrums of different color resistances with respect to the peak wavelengths of the emission spectrums of the corresponding light-emitting parts are substantially the same.

In a possible implementation, the color resistance includes a red color resistance for filtering out red light, a blue color resistance for filtering out blue light, and a green color resistance for filtering out green light;

a brightness attenuation spectrum of green light emitted through the green color resistance is located between a brightness attenuation spectrum of red light emitted through the red color resistance and a brightness attenuation spectrum of blue light emitted through the blue color resistance.

In a possible implementation, the light-emitting part includes an organic light-emitting layer.

In a possible implementation, the display substrate further includes an encapsulation layer between the pixel defining layer and the black matrix, and a touch layer between the encapsulation layer and the black matrix.

The embodiments of the present disclosure also provide a display device, including the display substrate provided by the embodiments of the present disclosure.

BRIEF DESCRIPTION OF THE DRAWINGS

FIG. 1 is a schematic diagram showing a contrast of angular color shift between an OLED display screen with POL structure and an OLED display screen with integrated COE structure;

FIG. 2 is a schematic diagram showing a contrast of angular brightness attenuation between an OLED display screen with POL structure and an OLED display screen with integrated COE structure;

FIG. 3 is a schematic diagram showing a contrast of specific parameters of angular characteristics between an OLED display screen with POL structure and an OLED display screen with integrated COE structure;

FIG. 4 is a schematic cross-sectional view of a display substrate provided by an embodiment of the present disclosure;

FIG. 5 is a first schematic diagram of a pixel opening and a black matrix opening provided by an embodiment of the present disclosure;

FIG. 6 is a second schematic diagram of a pixel opening and a black matrix opening provided by an embodiment of the present disclosure;

FIG. 7 is a third schematic diagram of a pixel opening and a black matrix opening provided by an embodiment of the present disclosure;

FIG. 8 is a fourth schematic diagram of a pixel opening and a black matrix opening provided by an embodiment of the present disclosure;

FIG. 9 is a fifth schematic diagram of a pixel opening and a black matrix opening provided by an embodiment of the present disclosure;

FIG. 10 is a first schematic diagram of a pixel structure arrangement provided by an embodiment of the present disclosure;

FIG. 11 is a schematic diagram of a pixel structure arrangement of a repeating unit in FIG. 10;

FIG. 12 is a schematic diagram of an angular brightness attenuation in case of the pixel structure arrangement in FIG. 11;

FIG. 13 is a schematic diagram of CIE trajectory at viewing angle W in case of the pixel structure arrangement in FIG. 11;

FIG. 14 is a schematic diagram of characteristic parameters at viewing angle W in case of the pixel structure arrangement in FIG. 11;

FIG. 15 is a schematic diagram of a pixel structure arrangement of a repeating unit in FIG. 16;

FIG. 16 is a second schematic diagram of a pixel structure arrangement provided by an embodiment of the present disclosure;

FIG. 17 is a schematic diagram of a pixel structure arrangement of a repeating unit in FIG. 18;

FIG. 18 is a third schematic diagram of a pixel structure arrangement provided by an embodiment of the present disclosure;

FIG. 19 is a schematic diagram of a pixel structure arrangement of a repeating unit in FIG. 20;

FIG. 20 is a fourth schematic diagram of a pixel structure arrangement provided by an embodiment of the present disclosure;

FIG. 21 is a simulation diagram of angular brightness attenuation of white light when a peak position of transmission spectrum of a green color resistance moves leftwards and rightwards;

FIG. 22 is a transmission spectrum of a green color resistance varying with angle;

FIG. 23 is a schematic diagram of an electroluminescence spectrum varying with angle;

FIG. 24 is a schematic diagram of an electroluminescence spectrum and a transmission spectrum of a green color resistance;

FIG. 25 is a schematic matching diagram of angular brightness attenuations of three types of light having red, green and blue light-emitting colors.

## DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

In order to keep the following description of the embodiments of the present disclosure clear and concise, detailed descriptions of known functions and known components are omitted in the present disclosure.

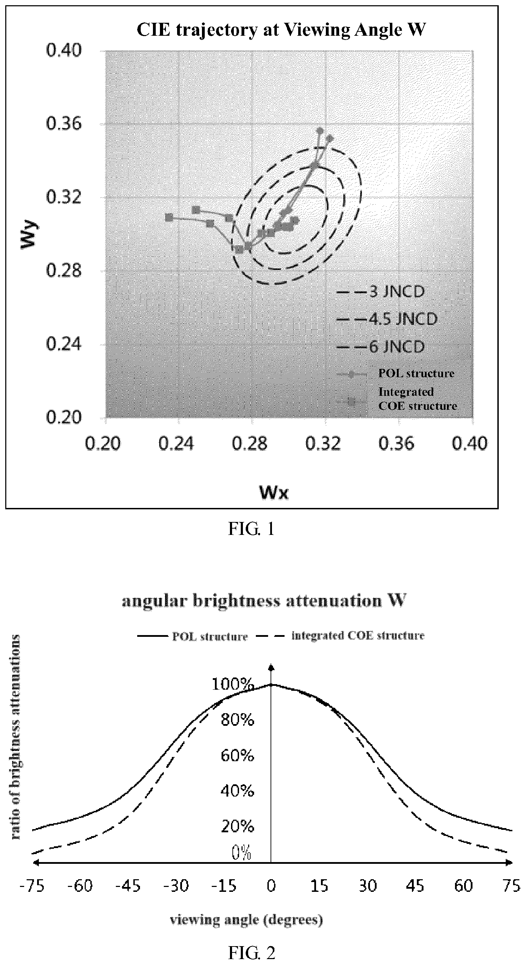

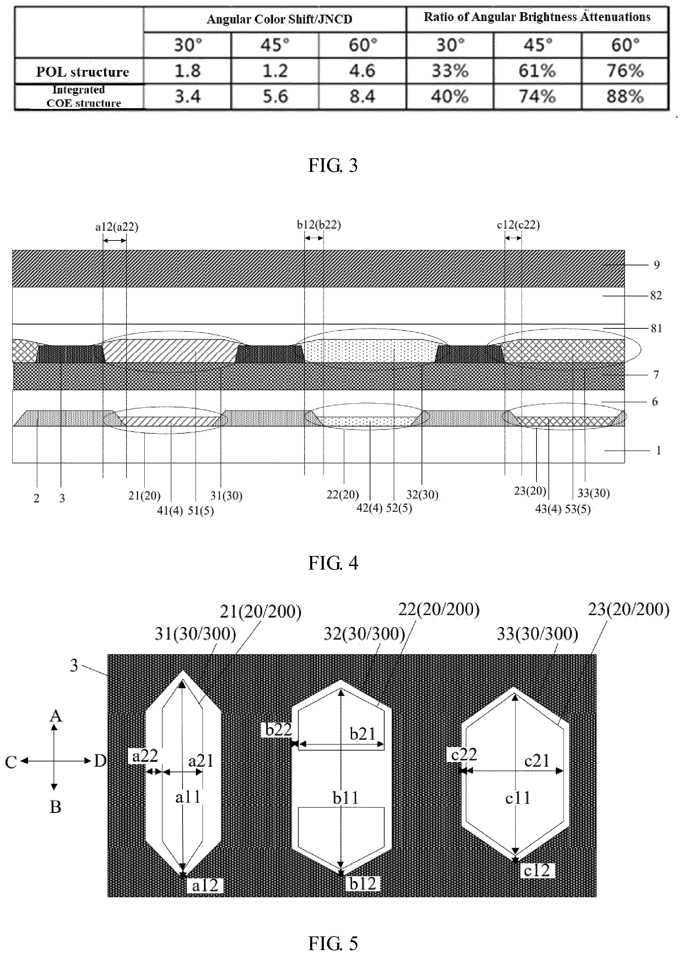

Replacing circular polarizer (POL) with color filter on encapsulation (COE) and black matrix on encapsulation is an effective method to improve the transmittance, and at the same time, a thinner display module can be obtained, which is also beneficial to the further development of rollable screens. However, the angular characteristics will be seriously deteriorated after introducing the COE structure into the organic electroluminescent display (OLED), as shown in FIG. 1, FIG. 2 and FIG. 3. FIG. 1 is a schematic diagram showing a contrast of angular color shift between an OLED display screen with POL structure and an OLED display screen with integrated COE structure; FIG. 2 is a schematic diagram showing a contrast of angular brightness attenuation between an OLED display screen with POL structure and an OLED display screen with integrated COE structure; and FIG. 3 is a schematic diagram showing a contrast of specific parameters of angular characteristics between an OLED display screen with POL structure and an OLED display screen with integrated COE structure. As can be seen from FIGS. 1, 2 and 3, both of the angular color shift and angular brightness attenuation of the OLED display screen become worse after integrated with the COE structure. This is mainly attributed to the following two reasons: on the one hand, the black matrix (BM) absorbs and blocks the light, and on the other hand, the color filter (CF) absorbs the light.

In view of this, an embodiment of the present disclosure provides a display substrate. As shown in FIGS. 4- 9, the display substrate includes:

a base substrate 1;

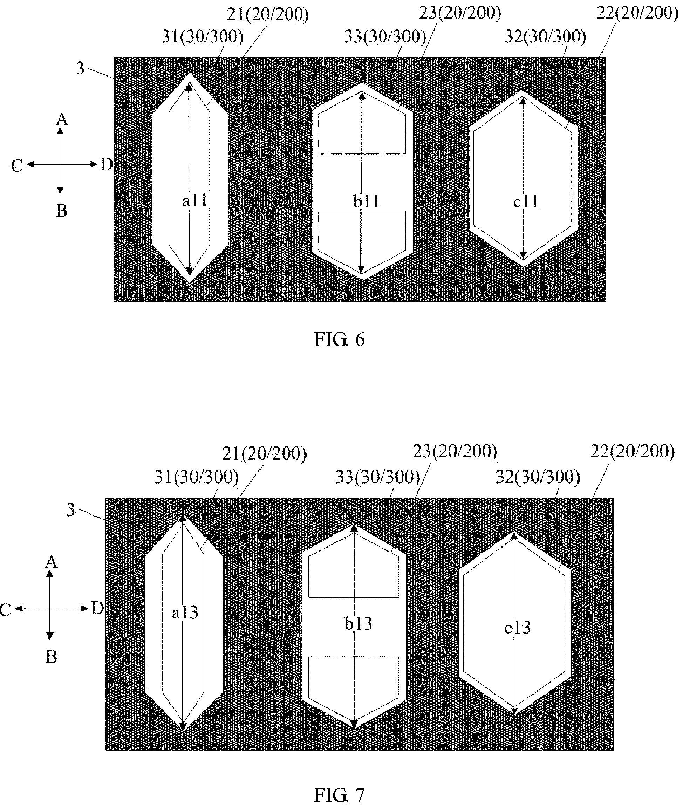

a pixel defining layer 2 located at a side of the base substrate 1, the pixel defining layer 2 has a plurality of pixel openings 20 emitting light of different colors, and the pixel openings 20 have pixel opening orthographic projections 200 on the base substrate 1; specifically, for example, the pixel openings 20 include a first pixel opening 21, a second pixel opening 22, and a third pixel opening 23, wherein the light-emitting colors of the first pixel opening 21, the second pixel opening 22, and the third pixel opening 23 are different; and

a black matrix 3 located at a side of the pixel defining layer 2 away from the base substrate 1, the black matrix 3 includes black matrix openings 30 corresponding to the pixel openings 20; specifically, for example, the black matrix openings 30 include a first black matrix opening 31 corresponding to the first pixel opening 21, a second black matrix opening 32 corresponding to the second pixel opening 22, and a third black matrix opening 33 corresponding to the third pixel opening 23; the black matrix openings 30 have black matrix opening orthographic projections 300 on the base substrate 1; as compared with the pixel opening 20, the black matrix opening 30 has an opening expansion, that is, the size of the black matrix opening 30 is larger, and the black matrix opening 30 is outwardly expanded with relative to the pixel opening 20; specifically, the opening expansion can be understood as a difference between the minimum opening position of the black matrix opening 30 and the minimum opening position of the pixel opening 20; for example, as shown in FIG. 4, the cross section of the black matrix opening 30 is a trapezoid with an upper opening larger than a lower opening, and the cross section of the pixel opening 20 is a trapezoid with an upper opening larger than a lower opening, and the opening expansion may refer to the lower opening of the black matrix opening 30 and the lower opening of the pixel opening 20; at the positions of at least two pixel openings 20 with different light-emitting colors, in a same direction parallel to the base substrate 1, the opening expansion is inversely proportional to the length of the pixel opening orthographic projection 200; specifically, for example, at the position of the first pixel opening 21, in the direction indicated by the arrow AB in FIG. 5, the opening expansion of the first black matrix opening 31 and the first pixel opening 21 is a12 (as shown in combination with FIGS. 6 and 7, a12 is half the difference between the length a13 of the first black matrix opening 31 and the length a11 of the first pixel opening 21), and the opening expansion is inversely proportional to the length a11 of the first pixel opening 21; in other words, the longer the length of the first pixel opening 21, the smaller the opening expansion at the position where the first pixel opening 21 can be set, that is, the smaller the expanded amount of the first black matrix opening 31 with relative to the first pixel opening 21.

In the embodiment of the present disclosure, at the position of the pixel opening 20, in the same direction parallel to the base substrate 1, the opening expansion is inversely proportional to the length of the pixel opening orthographic projection 200. If the size of the pixel opening 20 is larger, the expanded amount of the first black matrix opening 31 with relative to the first pixel opening 21 is smaller, and if the size of the pixel opening 20 is smaller, the expanded amount of the first black matrix opening 31 with relative to the first pixel opening 21 is larger. In this way, for pixel openings with different light-emitting colors and different opening sizes, the brightness attenuations at the pixel openings can be balanced to achieve a general balance, and the problems that the color shift and brightness attenuation at larger viewing angles become worse in final display caused by inconsistent influences of black matrix openings on different colors (the smaller of the size of the pixel opening, the greater the angular brightness attenuation) can be avoided.

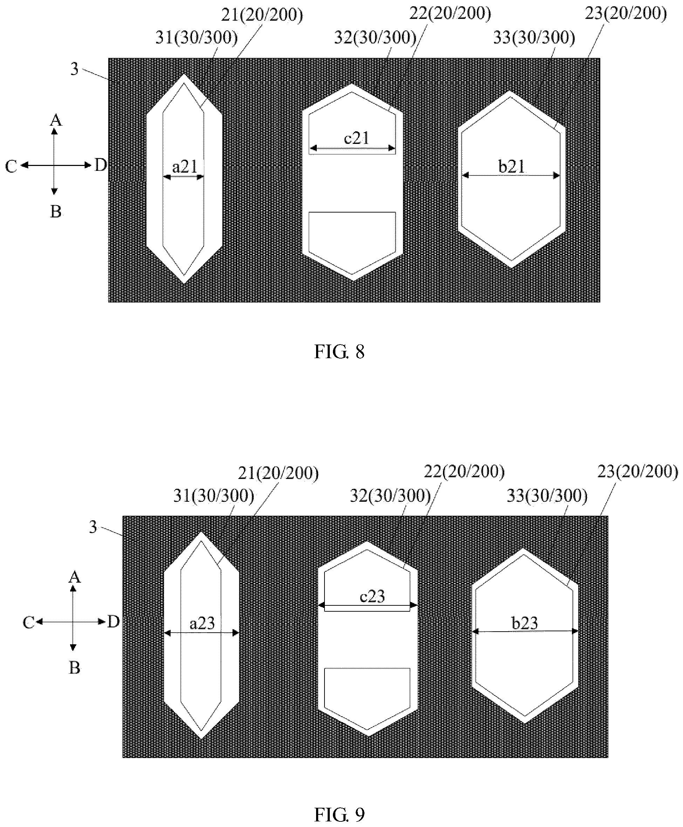

In one possible implementation, the pixel opening orthographic projection 20 is a polygon; the pixel opening 20 includes a first pixel opening 21 emitting light of a first color, and the first pixel opening 21 has a first side extending in the first direction AB, and the length of the first side of the first pixel opening 21 is greater than or equal to the lengths of the remaining sides of the first pixel opening 21, and greater than or equal to the maximum side lengths of the pixel openings of other light-emitting colors, that is, the first pixel opening 21 is a pixel opening 20 with the longest side length, the first side is the longest side of the first pixel opening 21, and the first direction is the direction of the first side. At the positions of at least two pixel openings 20 with different light-emitting colors, in a direction parallel to the base substrate 1 and perpendicular to the first direction AB (as shown by the arrow CD in FIG. 5), the opening expansion is inversely proportional to the length of the orthographic projection of the pixel opening 20. Specifically, as shown in FIG. 5, for example, at the position of the first pixel opening 21, in the direction parallel to the base substrate 1 and perpendicular to the first direction (as shown by the arrow CD in FIG. 5), the opening expansion of the first black matrix opening 31 and the first pixel opening 21 is a22 (as shown in combination with FIGS. 8 and 9, a22 is half the difference between the length a23 of the first black matrix opening 31 and the length a21 of the first pixel opening 21), and this opening expansion a22 is inversely proportional to the length a21 of the first pixel opening 21. In the embodiment of the present disclosure, at the positions of at least two pixel openings 20 with different light-emitting colors, in the direction parallel to the base substrate 1 and perpendicular to the first direction (as shown by the arrow CD in FIG. 5), the opening expansion is inversely proportional to the length of the pixel opening orthographic projection 200, thereby further alleviating the problems that the angular color shift and the angular brightness attenuation become worse in the direction perpendicular to the first direction AB.

In one possible implementation, at the positions of at least two pixel openings 20 with different light-emitting colors, in the first direction AB parallel to the base substrate 1, the opening expansion is inversely proportional to the length of the pixel opening orthographic projection 200. In the embodiment of the present disclosure, it can be specifically configured that the opening expansion of the black matrix opening 30 in the direction where the longest side of the pixel opening 20 is located is inversely proportional to the length of the orthographic projection of the pixel opening 20, which can alleviate the problems that the angular color shift and the angular brightness attenuation become worse in the first direction AB.

In one possible embodiment, in the same direction parallel to the base substrate 1, the ratio of opening expansions of at least two pixel openings with different light-emitting colors is approximately inversely proportional to the ratio of lengths of orthographic projections of the pixel openings with corresponding light-emitting colors. Specifically, for example, in the same direction parallel to the base substrate 1, if the ratio of the length of the orthographic projection of the pixel opening emitting red light to the length of the orthographic projection of the pixel opening emitting green light is a: b, the ratio of the opening expansion at the pixel opening emitting red light to the opening expansion at the pixel opening emitting green light is b: a. In the embodiment of the present disclosure, in the same direction parallel to the base substrate 1, the ratio of opening expansions of at least two pixel openings with different light-emitting colors is approximately inversely proportional to the ratio of lengths of orthographic projections of the pixel openings with corresponding light-emitting colors, so that the brightness attenuations of at least two pixel openings with different light-emitting colors can be approximately balanced, and the problems that the angular color shift and the angular brightness attenuation at large viewing angles become worse in display can be avoided.

In one possible implementation, in the same direction parallel to the base substrate 1, the ratio of opening expansions of various pixel openings with different light-emitting colors is approximately inversely proportional to the ratio of lengths of the orthographic projections of the pixel openings with the corresponding light-emitting colors. Specifically, for example, in the same direction parallel to the base substrate 1, the length of the orthographic projection of the pixel opening emitting red light is a, the length of the orthographic projection of the pixel opening emitting green light is b, the length of the orthographic projection of the pixel opening emitting blue light is c, and given that the opening expansion corresponding to the pixel opening with the maximum orthographic projection is 1; if a<b<c, that is, if the opening expansion at the pixel opening emitting blue light is 1, the opening expansion at the pixel opening emitting red light is y=c/a (that is, a:c=1:y), similarly, the opening expansion at the pixel opening emitting green light is x=c/b (that is, b:c=1:x); as a result, the ratio of the opening expansion y at the pixel opening emitting red light to the opening expansion x at the pixel opening emitting green light to the opening expansion (valued as 1) at the pixel opening emitting blue light is y : x : 1= c/a : c/b : 1. Specifically, for example, in the first direction AB, the length of the orthographic projection of the pixel opening emitting red light is 15.45 $\mu$m, the length of the orthographic projection of the pixel opening emitting green light is 18.55 $\mu$m, and the length of the orthographic projection of the pixel opening emitting blue light is 34 $\mu$m, that is, the ratio of these three lengths is approximately 1: 1.2:2.2; then a ratio of the opening expansion at the pixel opening emitting red light to the opening expansion at the pixel opening emitting green light to the opening expansion at the pixel opening emitting blue light is 2.2:1.8:1. In the embodiment of the present disclosure, in the same direction parallel to the base substrate 1, the ratio of opening expansions of various pixel openings with different light-emitting colors is approximately inversely proportional to the ratio of lengths of the orthographic projections of the pixel openings with corresponding light-emitting colors, so that the brightness attenuations of pixel openings emitting red light, pixel openings emitting green light and pixel openings emitting blue light can be approximately balanced, and the problems that the angular color shift and the angular brightness attenuation at larger viewing angles become worse during display can be avoided.

In order to more clearly understand the arrangement of black matrix openings in the display substrate provided by the embodiment of the present disclosure, the following examples are given.

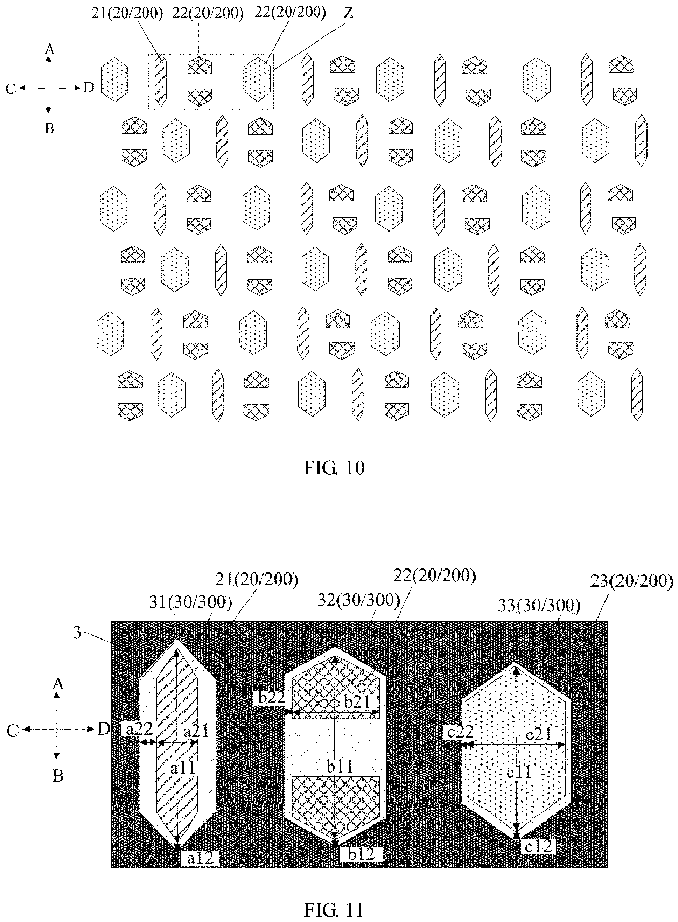

For example, as shown in FIGS. 10 and 11, the first pixel opening 21 is a red pixel opening emitting red light, and the pixel openings further include a blue pixel opening emitting blue light and a green pixel opening emitting green light. Specifically, the green pixel opening may include two sub-green pixel openings. Specifically, for example, the second pixel opening 22 is a green pixel opening emitting green light, and the third pixel opening 23 is a blue pixel opening emitting blue light. One blue pixel opening (i.e., the third pixel opening 23), one red pixel opening (i.e., the first pixel opening 21) and one green pixel opening (i.e., the second pixel opening 22) are sequentially arranged along the direction perpendicular to the first direction (i.e., the direction indicated by the arrow CD) to constitute one repeating unit Z, and a plurality of repeating units Z are sequentially arranged along the direction perpendicular to the first direction (i.e., the direction indicated by the arrow CD) to form a pixel opening row;

In the pixel arrangement as shown in FIGS. 10 and 11, for example, in the direction perpendicular to the first direction AB (the direction indicated by the arrow CD), the width a21 of the red pixel opening (i.e., the first pixel opening 21), the width b21 of the green pixel opening (i.e., the second pixel opening 22) and the width c21 of the blue pixel opening (i.e., the third pixel opening 23) are 10.2 $\mu$m, 22.6 $\mu$m, and 25 $\mu$m, respectively, and the ratio is approximately 1:2.2:2.5. If the ratio of the opening expansion a22 at the red pixel opening (i.e., the first pixel opening 21), the opening expansion b22 at the green pixel opening (i.e., the second pixel opening 22) and the opening expansion c22 at the blue pixel opening (i.e., the third pixel opening 23) is designed as 2.5:1:1, the angular brightness attenuations of different colors are almost subjected to the same influences caused by the black matrix openings 30. In the first direction AB, the width a11 of the red pixel opening (i.e., the first pixel opening 21), the width b11 of the green pixel opening (i.e., the second pixel opening 22) and the width c11 of the blue pixel opening (i.e., the third pixel opening 23) are 51.19 $\mu$m, 47.65 $\mu$m and 42.64 $\mu$m, respectively, that is, the sizes of widths of various pixel openings 20 are relatively large and the ratio is close to 1:1:1, then the same opening expansions may be designed. It should be noted that two sub-pixel openings of the green pixel opening correspond to one black matrix opening (that is, there is no black matrix in the middle of the two sub-green pixel openings).

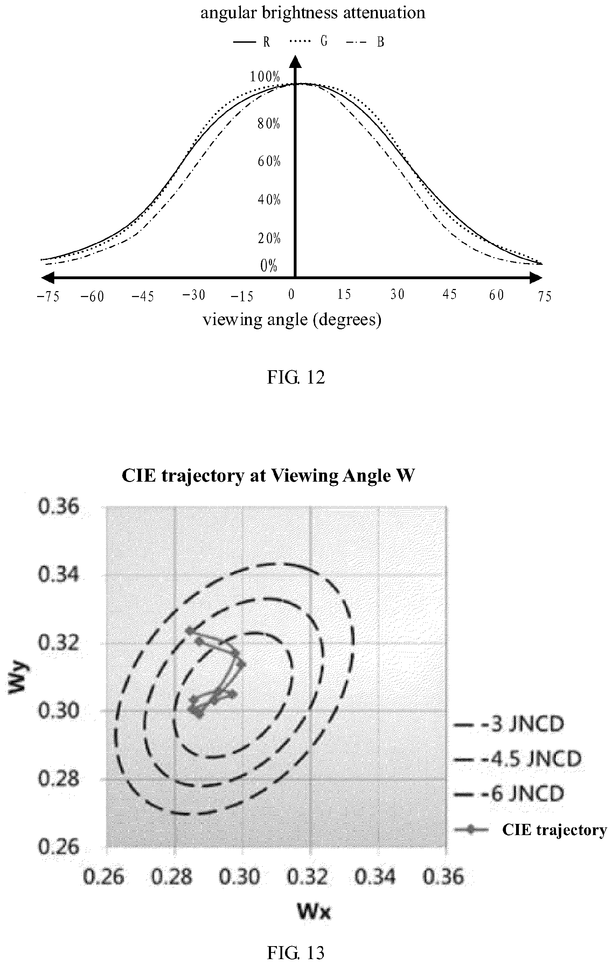

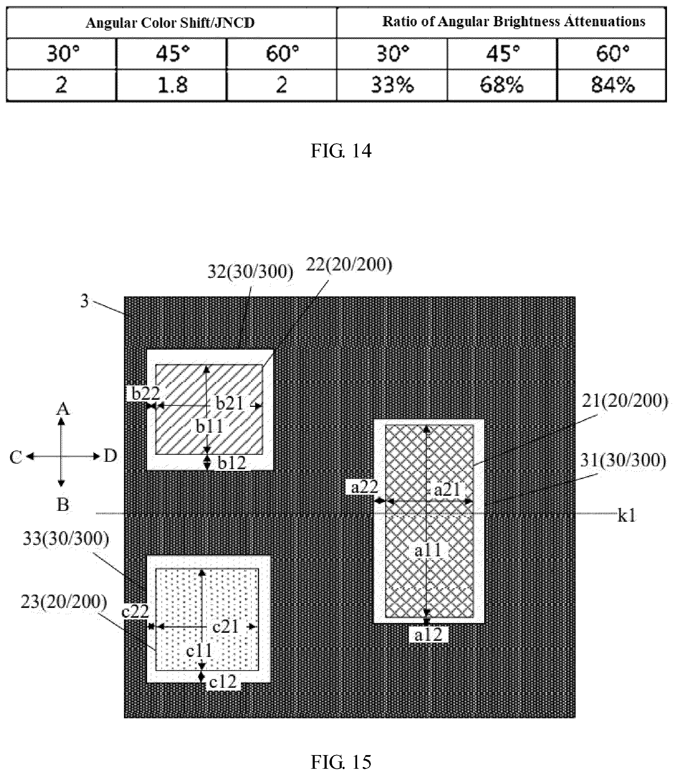

After the above matching process, it can be designed that, in the direction perpendicular to the first direction AB (the direction indicated by the arrow CD), the opening expansion a22 at the red pixel opening (i.e., the first pixel opening 21), the opening expansion b22 at the green pixel opening (i.e., the second pixel opening 22) and the opening expansion c22 at the blue pixel opening (i.e., the third pixel opening 23) are 5 $\mu$m, 2 $\mu$m and 2 $\mu$m, respectively; and in the first direction AB, the opening expansion a12 at the red pixel opening (i.e., the first pixel opening 21), the opening expansion b12 at the green pixel opening (i.e., the second pixel opening 22) and the opening expansion c12 at the blue pixel opening (i.e., the third pixel opening 23) are 2 $\mu$m, 2 $\mu$m and 2 $\mu$m, respectively, as shown in FIG. 11. The angular brightness attenuation matching at the red pixel opening (i.e., the first pixel opening 21), the green pixel opening (i.e., the second pixel opening 22) and the blue pixel opening (i.e., the third pixel opening 23) is shown in FIG. 12, the CIE trajectory of viewing angle W is shown in FIG. 13, and characteristic parameters of viewing angle W are shown in Fig.14. As can be seen from FIG. 12, FIG. 13 and FIG. 14, after the above matching design, the angular color shift of OLED screen with COE structure is obviously alleviated, and the angular color shifts at 30 degrees, 45 degrees and 60 degrees are reduced to 2 JNCD, 1.8 JNCD and 2 JNCD respectively which is close to the OLED screen with POL structure, and the angular color shift at a large viewing angle of 60 degrees is lower than that of OLED screen with POL structure. At the same time, the angular brightness attenuation is also significantly alleviated; the angular brightness attenuation at 30-degree viewing angle is not affected by the COE structure, and the angular brightness attenuations at 45-degree viewing angle and 60-degree viewing angle are subjected to reduced influences from the COE structure.

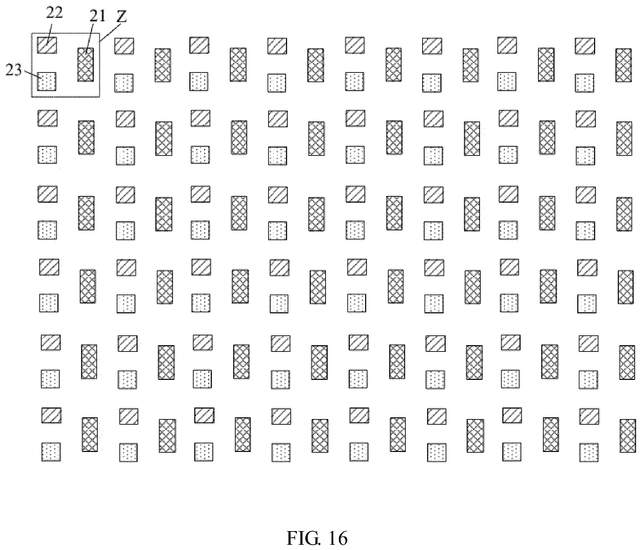

For another example, as shown in FIGS. 15 and 16, the first pixel opening 21 is a blue pixel opening emitting blue light, and the pixel openings 20 further include a red pixel opening emitting red light and a green pixel opening emitting green light. Specifically, for example, the second pixel opening 22 is a red pixel opening emitting red light and the third pixel opening 23 is a green pixel opening emitting green light. One red pixel opening (second pixel opening 22), one green pixel opening (third pixel opening 23) and one blue pixel opening (first pixel opening 21) constitute one repeating unit Z; and in the repeating unit Z, the red pixel opening (second pixel opening 22) and the green pixel opening (third pixel opening 23) are arranged along the first direction AB; a straight line k1 passing through the center of the blue pixel opening (first pixel opening 21) and perpendicular to the first direction is located at a gap between the red pixel opening (second pixel opening 22) and the green pixel opening (third pixel opening 23); specifically, the red pixel opening (second pixel opening 22) and the green pixel opening (third pixel opening 23) can be symmetrical about the straight line k1; a plurality of repeating units Z are sequentially arranged along the direction perpendicular to the first direction AB (that is, the direction indicated by the arrow CD) to form a pixel opening row.

Under the pixel arrangement as shown in FIGS. 15 and 16, for example, in the direction perpendicular to the first direction AB (the direction indicated by the arrow CD), the width b21 of the red pixel opening (i.e., the second pixel opening 22), the width c21 of the green pixel opening (i.e., the third pixel opening 23) and the width a21 of the blue pixel opening (i.e., the first pixel opening 21) are 18.7 $\mu$m, 18.7 $\mu$m, and 15.3 $\mu$m respectively, and the ratio is approximately 1.2:1.2:1. If the ratio of the opening expansion b22 at the red pixel opening (that is, the second pixel opening 22), the opening expansion c22 at the green pixel opening (that is, the third pixel opening 23) and the opening expansion a22 at the blue pixel opening (that is, the first pixel opening 21) is designed as 1:1:1.2, the angular brightness attenuations of different colors will be subjected to almost the same influences from the black matrix openings.

In the first direction AB, the width b11 of the red pixel opening (i.e., the second pixel opening 22), the width c11 of the green pixel opening (i.e., the third pixel opening 23) and the width a11 of the blue pixel opening (i.e., the first pixel opening 21) are 15.45 $\mu$m, 18.55 $\mu$m and 34 $\mu$m, respectively, and the ratio is approximately 1: 1.2:2.2. The ratio of the opening expansion b12 at the red pixel opening (i.e., the second pixel opening 22), the opening expansion c12 at the green pixel opening (i.e., the third pixel opening 23) and the opening expansion a12 at the blue pixel opening (i.e., the first pixel opening 21) can be designed as 2.2: 1.8: 1.

After the above matching process, it can be designed that, in the direction perpendicular to the first direction AB (the direction indicated by the arrow CD), the opening expansion b22 at the red pixel opening (i.e., the second pixel opening 22), the opening expansion c22 at the green pixel opening (i.e., the third pixel opening 23) and the opening expansion a22 at the blue pixel opening (i.e., the first pixel opening 21) are 2 μm, 2 μm and 2.4 μm, respectively; and in the first direction AB, the opening expansion b12 at the red pixel opening (i.e., the second pixel opening 22), the opening expansion c12 at the green pixel opening (i.e., the third pixel opening 23) and the opening expansion a12 at the blue pixel opening (i.e., the first pixel opening 21) are 5.2 μm, 4.2 μm and 2.4 μm, respectively, as shown in FIG. 15.

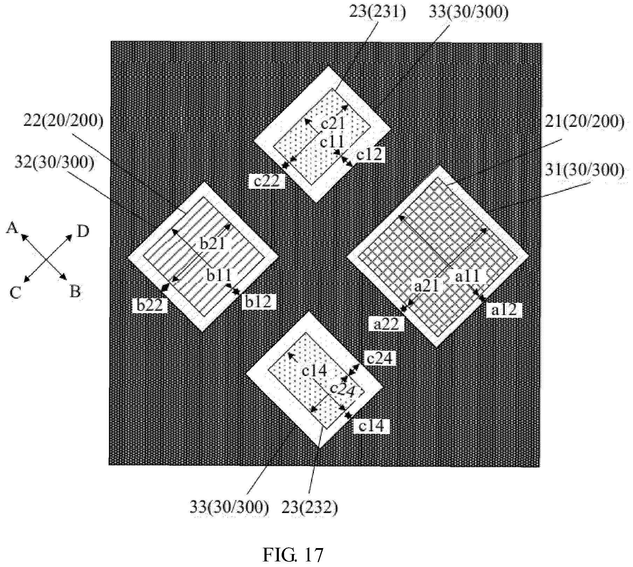

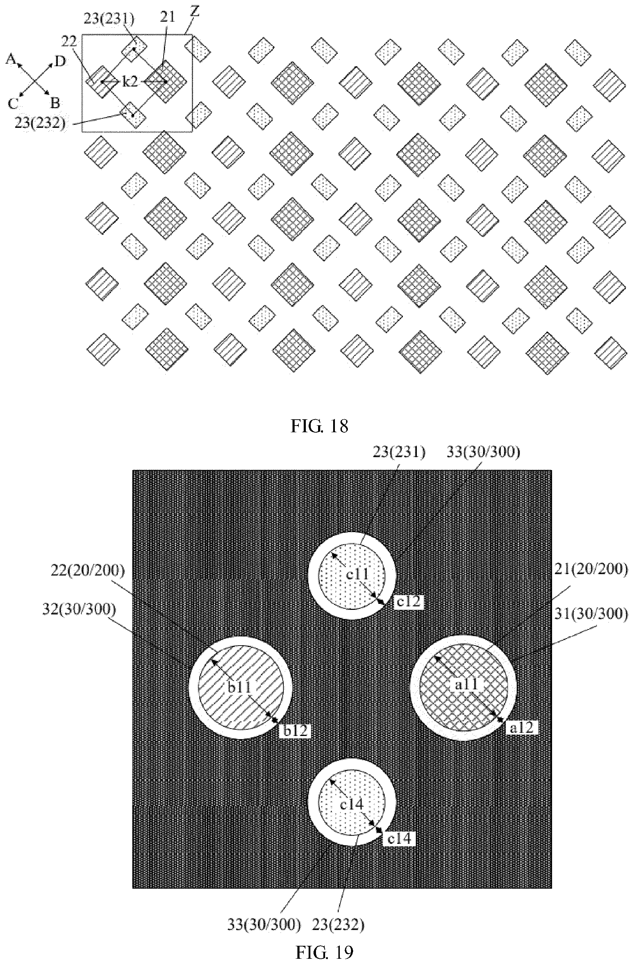

For another example, as shown in FIGS. 17 and 18, the first pixel opening 21 is a blue pixel opening emitting blue light, and the pixel openings 20 further include a red pixel opening emitting red light, as well as a first green pixel opening and a second green pixel opening emitting green light. Specifically, for example, the second pixel opening 22 is a red pixel opening emitting red light, and the third pixel opening 23 includes a first green pixel opening 231 and a second green pixel opening 232 emitting green light; one red pixel opening (second pixel opening 22), one first green pixel opening 231, one second green pixel opening 232, and one blue pixel opening (first pixel opening 21) constitute one repeating unit Z; and in the repeating unit Z, the center of the red pixel opening (second pixel opening 22), the center of the blue pixel opening (first pixel opening 21), the center of the first green pixel opening 231, and the center of the second green pixel opening 232 constitute a quadrilateral; two sides of the quadrilateral are parallel to the first direction AB, and the other two sides are perpendicular to the first direction AB; the connecting line between the center of the red pixel opening (second pixel opening 22) and the center of the blue pixel opening (first pixel opening 21) constitutes a first diagonal line k2 of the quadrilateral, and the repeating units Z are arranged in sequence along a direction parallel to the first diagonal line k2 to form a pixel opening row.

In the pixel arrangement as shown in FIG. 17 and FIG. 18, the blue pixel opening (first pixel opening 21) has the longest side, and the direction in which the longest side of the blue pixel opening (first pixel opening 21) is located is taken as the first direction, then in the direction perpendicular to the first direction AB (the direction indicated by the arrow CD), the pixel width b21 of the red pixel opening (second pixel opening 22), the pixel width c21 of the first green pixel opening 231, the pixel width c24 of the second green pixel opening 232 and the pixel width a21 of the blue pixel opening (first pixel opening 21) are 20.2 μm, 19.35 μm, 27.1 μm and 12.13 μm, respectively, and the ratio is approximately 1:1:1.4:0.6; it can be designed that, a ratio of the opening expansion b22 of the red pixel opening (second pixel opening 22), the opening expansion c22 of the first green pixel opening 231, the opening expansion c24 of the second green pixel opening 232 and the opening expansion a22 of the blue pixel opening (first pixel opening 21) is 1.4:1.4:1:2.2, then the angular brightness attenuations of different colors are almost subjected to the same influences caused by the black matrix openings. In the first direction AB, the pixel width b11 of the red pixel opening (second pixel opening 22), the pixel width c11 of the first green pixel opening 231, the pixel width c14 of the second green pixel opening 232 and the pixel width a11 of the blue pixel opening (first pixel opening 21) are 20.2 μm, 12.13 μm, 27.1 μm and 19.35 μm, respectively, and the ratio is about 1:0.6:2.2: 1; it can be designed that the ratio of the opening expansion b 12 of the red pixel opening (second pixel opening 22), the opening expansion c12 of the first green pixel opening 231, the opening expansion c14 of the second green pixel opening 232 and the opening expansion a12 of the blue pixel opening (first pixel opening 21) is 1.4: 2.2: 1: 1.4.

After the above matching process, it can be designed that, in the direction perpendicular to the first direction AB (the direction indicated by the arrow CD), the opening expansion b22 of the red pixel opening (the second pixel opening 22), the opening expansion c22 of the first green pixel opening 231, the opening expansion c24 of the second green pixel opening 232 and the opening expansion a22 of the blue pixel opening (the first pixel opening 21) are 2.8 μm, 2.8 μm, 2 μm and 4.4 μm respectively; in the first direction AB, the opening expansion b12 of the red pixel opening (second pixel opening 22), the opening expansion c12 of the first green pixel opening 231, the opening expansion c14 of the second green pixel opening 232 and the opening expansion a12 of the blue pixel opening (first pixel opening 21) are 2.8 μm, 4.4 μm, 2 μm and 2.8 μm, respectively. Because the first green pixel opening 231 and the second green pixel opening 232 have different sizes in the first direction AB and the direction perpendicular to the first direction AB, they need to be designed according to the pixel opening sizes respectively.

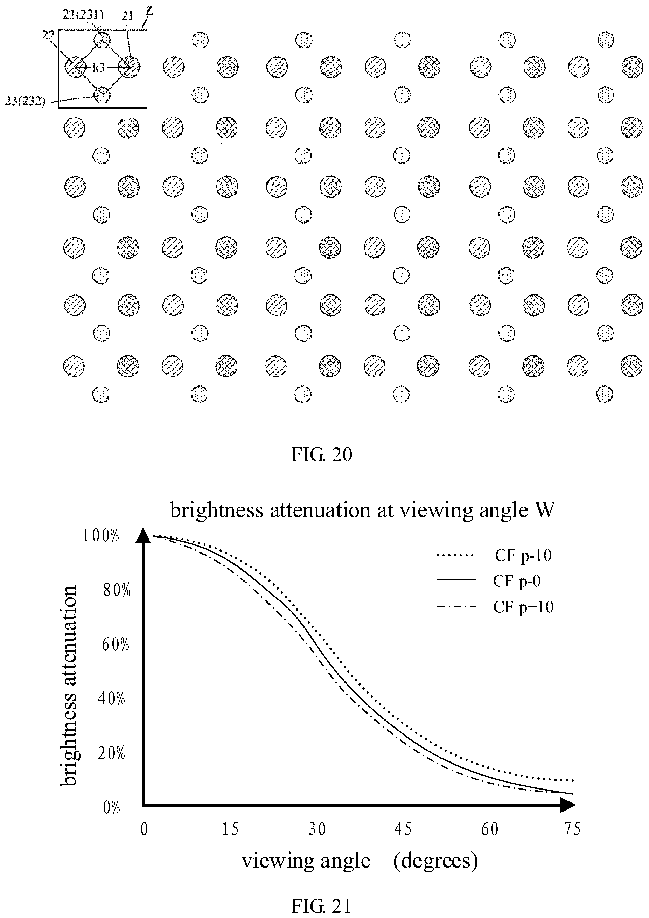

For another example, as shown in FIGS. 19 and 20, the orthographic projection of the pixel opening 20 on the base substrate 1 is circular, and the pixel openings 20 include a blue pixel opening emitting blue light, a red pixel opening emitting red light, as well as a first green pixel opening and a second green pixel opening emitting green light. Specifically, for example, the first pixel opening 21 is a blue pixel opening emitting blue light, the second pixel opening 22 is a red pixel opening emitting red light, and the third pixel opening 22 includes a first green pixel opening 231 and a second green pixel opening 232 emitting green light; one red pixel opening (second pixel opening 22), one first green pixel opening 231, one second green pixel opening 232, and one blue pixel opening (first pixel opening 21) constitute one repeating unit Z; and in the repeating unit Z, the center of the red pixel opening (second pixel opening 22), the center of the blue pixel opening (first pixel opening 21), the center of the first green pixel opening 231, and the center of the second green pixel opening 232 constitute a quadrilateral, the connecting line between the center of the red pixel opening (the second pixel opening 22) and the center of the blue pixel opening (the first pixel opening 21) forms a second diagonal line k3 of the quadrilateral, and the repeating units Z are sequentially arranged along the direction parallel to the second diagonal line k3 to form a pixel opening row.

Under the pixel arrangement as shown in FIGS. 19 and 20, the red pixel opening (second pixel opening 22), the first green pixel opening 231, the second green pixel opening 232 and the blue pixel opening (first pixel opening 21) are all circular in shapes, with diameters of 20 $\mu$m, 15 $\mu$m, 15 $\mu$m and 20 $\mu$m respectively, and the ratio is 1:0.75:0.75:1; if the ratio of the opening expansion b12 of the red pixel opening (second pixel opening 22), the opening expansion c12 of the first green pixel opening 231, the opening expansion c14 of the second green pixel opening 232 and the opening expansion a12 of the blue pixel opening (first pixel opening 21) is designed as 1:1.3:1.3:1, the angular brightness attenuations of different colors are almost subjected to the same influences caused by the black matrix openings. Because the shape of the pixel structure is circular, the ratios of the opening expansions are designed as the same in all directions.

After the above matching process, the opening expansion b12 of the red pixel opening (second pixel opening 22), the opening expansion c12 of the first green pixel opening 231, the opening expansion c14 of the second green pixel opening 232 and the opening expansion a12 of the blue pixel opening (first pixel opening 21) are 2 $\mu$m, 2.6 $\mu$m, 2.6 $\mu$m and 2 $\mu$m, respectively.

In one possible implementation, as shown in combination with FIG. 5, the range of the opening expansions is 2 nm to 10 nm. In the embodiment of the present disclosure, due to the process limitation, the opening expansions need to be greater than 2 nm and smaller than 10 nm, which can avoid the problem that no black matrix exits between two types of pixels, which is attributed to the excessively small pixel defining layer between these two types of pixels.

In one possible implementation, as shown in combination with FIG. 4, the display substrate further includes a light-emitting part 4 located at the pixel opening 20, and a color film layer located at the side of the black matrix 3 away from the pixel defining layer 2; the color film layer includes a color resistance located at the black matrix opening 30. Specifically, the light-emitting part 4 may include a first light-emitting part 41 at the first pixel opening 21, a second light-emitting part 42 at the second pixel opening 22, and a third light-emitting part 43 at the third pixel opening 23; the color resistance 5 includes a first color resistance 51 at the first black matrix opening 31, a second color resistance 52 at the second black matrix opening 32, and a third color resistance 53 at the third black matrix opening 33. The peak wavelength of the transmission spectrum of the color resistor 5 is blue-shifted with respect to the peak wavelength of the emission spectrum of the corresponding light-emitting part 4; specifically, for example, the peak wavelength of the transmission spectrum of the first color resistor 51 is blue-shifted with respect to the peak wavelength of the emission spectrum of the corresponding first light-emitting part 41; the peak wavelength of the transmission spectrum of the second color resistor 52 is blue-shifted with respect to the peak wavelength of the emission spectrum of the corresponding second light-emitting part 42; and the peak wavelength of the transmission spectrum of the third color resistor 53 is blue-shifted with respect to the peak wavelength of the emission spectrum of the corresponding third light-emitting part 43. Specifically, the peak wavelength of the transmission spectrum of the color resistor 5 is blue-shifted by 10 nm to 15 nm with respect to the peak wavelength of the emission spectrum of the corresponding light-emitting part 4. In the embodiment of the present disclosure, referring to FIG. 21 which shows the simulation results of angular brightness attenuations of white light when the peak position of the CF transmission spectrum at the green pixel opening (for example, the green pixel opening is the third pixel opening 23) moves leftwards and rightwards. In the figure, CF p-0 indicates that the peak position of the emission spectrum of the light-emitting part 4 emitting green light is consistent with the corresponding peak position of the transmission spectrum of the green color resistance; CF p-10 indicates that the peak of the transmission spectrum of the green color resistance is blue-shifted by 10 nm with relative to the peak of the emission spectrum of the light-emitting part 4 emitting green light, and CF p+10 indicates that the peak of the transmission spectrum of the green color resistance is red-shifted by 10 nm with relative to the peak of the emission spectrum of the green light-emitting part 4 emitting green light. From the simulation results, it can be seen that the peak wavelength of the transmission spectrum of the color resistance 5 is blue-shifted with relative to the peak wavelength of the emission spectrum of the corresponding light-emitting part 4, which can greatly reduce the influence of the color resistance 5 on the angular brightness attenuation. What needs to be explained here is that only the green color resistance is described by way of example, and such adjustment is also applicable to the red color resistance and the blue color resistance.

In one possible implementation, the color film layer can also be located at the side of the black matrix 3 facing the pixel defining layer 2.

The principle that why the adjustment of the blue shift of the peak wavelength of the transmission spectrum of the color resistor 5 with relative to the peak wavelength of the emission spectrum of the corresponding light-emitting part 4 can alleviate the influence of the color resistance 5 on the angular brightness attenuation will be further explained below.

The absorbance formula is expressed as

$$A=\lg(I_0/I)=kcL \quad (1),$$

where $I_0$ is an intensity of incident light, I is an intensity of transmitted light, k is an absorption coefficient, c is a solution concentration for forming color film, and L is an optical path. According to the absorbance formula (1), it can be obtained that

$$\lg T=\lg(I/I_0)=-kcL \quad (2),$$

from which the relational expression between the transmittance and the thickness of color filter film is calculated as

$$T=T_0^{(L/L0)} \quad (3),$$

while the optical path $L_\theta$ of light passing through the color filter film at viewing angles is

$$L_\theta=L_0/\cos\theta \quad (4).$$

According to formulas (3) and (4), the transmittance at viewing angles can be obtained as

$$T_\theta= T_0^{(1/\cos\theta)} \quad (5).$$

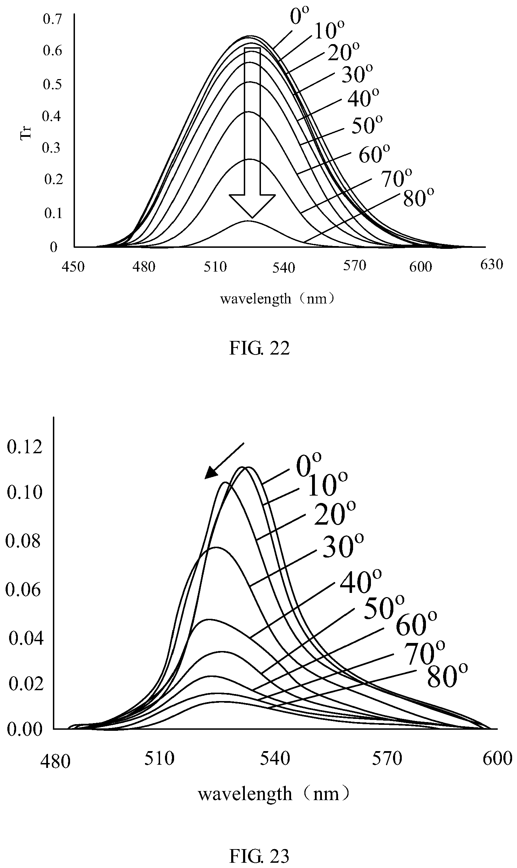

FIG. 22 is a transmission spectrum of a green color resistance varying with angle. It can be seen from FIG. 22 that the transmission spectrum is considerably dropped at larger angles, which leads to the acceleration of the attenuation of the transmission spectrum.

For electroluminescent devices, the enhanced spectrum of microcavity is referred to as EL spectrum for short, and the intrinsic spectrum of material is referred to as PL spectrum for short. The relationship between these two spectrums is expressed as EL(k) =PL(k) $G_{cav}$ ($\lambda$) (6), and the gain $G_{cav}(\lambda)$ of the microcavity is:

$$G_{cav.}(\lambda) = \frac{|E_2|^2}{|E_0|^2}\frac{\tau_{cav.}}{\tau_0} = \left[1-\frac{4\sqrt{R_1}sin^2\left(\frac{\varphi_1-2kL_1}{2}\right)}{\left(1+\sqrt{R_1}\right)^2}\right] * \left[\frac{T_2\left(1+\sqrt{R_1}\right)^2}{\left(1-\sqrt{R_1R_2}\right)^2+4\sqrt{R_1R_2}sin^2\left(\frac{\varphi_1+\varphi_2-2kL}{2}\right)}\right] * \frac{\tau_{cav.}}{\tau_0} \quad (7).$$

Among them, $\tau_{cav}$ and $\tau_0$ are average lifetimes of molecular excited states in microcavity and free space, respectively; R1 and R2 represent the reflectivity of opaque electrode and semi-transparent electrode, respectively (the opaque electrode and the semi-transparent electrode can be two opposite electrodes of the light-emitting device, respectively), k represents the wave vector in organic layer, φ1 and φ2 represent the reflection phase shift of the opaque electrode and the semi-transparent electrode respectively, $L_1$ is the optical distance to the opaque electrode, $T_2$ is the transmittance of the semi-transparent electrode, and L is the length of optical cavity.

The gain $G_{cav}(\lambda)$ of the microcavity is blue-shifted with the increase of the angle, and the relational expression between the peak position and the angle is

$$\lambda_m = \frac{4\pi nL cos\theta}{\phi_m - 2\pi m} \quad (8).$$

From the formula (8), it can be seen that the larger θ is, the smaller cos θ is, and the smaller λm is, that is, the peak λm of the gain spectrum of the microcavity is blue-shifted; further, because the intrinsic spectrum of material remains unchanged, the EL spectrum is blue-shifted. The electroluminescence spectrum (EL spectrum) at viewing angles will be blue-shifted, as shown in FIG. 23.

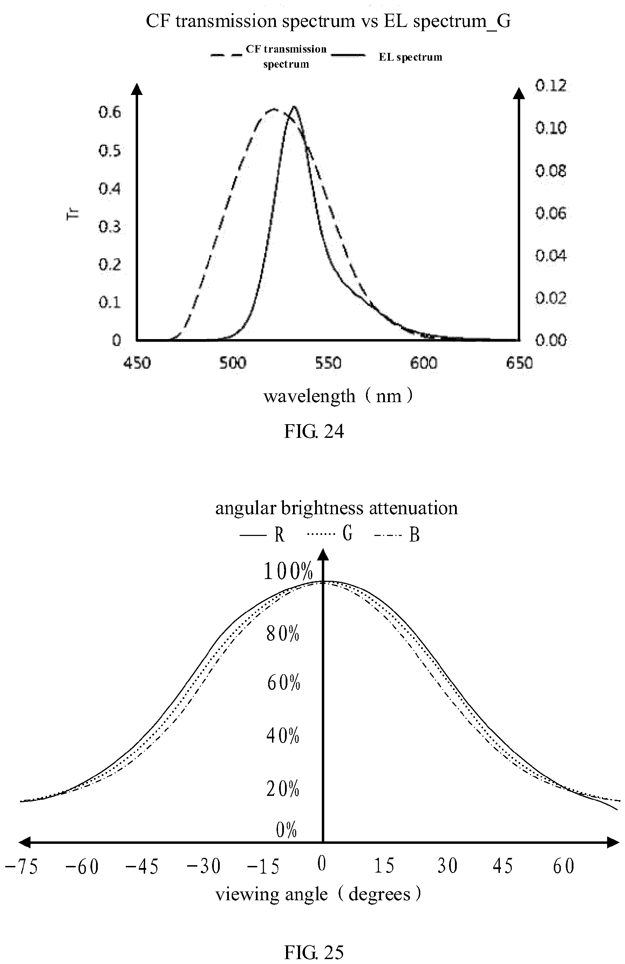

When the peak wavelength λm of the EL spectrum is red-shifted by more than 10 nm from the peak of the CF transmission spectrum at the front viewing angle (i.e., 0°), as shown in the positional relationship of FIG. 24, the EL spectrum will be moved in the direction of increasing the CF transmittance (i.e., moving to the left in FIG. 24) at a large viewing angle, and the position of the maximum CF transmittance coincides with the position of the maximum EL spectrum, so the overall transmittance is increased, thereby reducing the transmittance decrease caused by the increase of optical path at the viewing angle and achieving the purpose of slowing down the brightness attenuation.

In one possible implementation, the peak wavelengths of transmission spectrums of different color resistances 5 have approximately the same blue-shifted lengths with respect to the peak wavelengths of emission spectrums of the corresponding light-emitting parts 4. Specifically, the blue-shifted lengths of the peak wavelengths of the transmission spectrums of different color resistances 5 are almost the same with respect to the peak wavelengths of the emission spectrums of the corresponding light-emitting parts 4, which can be understood as: the blue-shifted lengths of the peak wavelengths of the transmission spectrums of different color resistances with respect to the peak wavelengths of the emission spectrums of the corresponding light-emitting parts 4 are not more than 5 nm.

In one possible implementation, as shown in FIG. 4, the color resistance 4 includes a red color resistance that filters out red light, a blue color resistance that filters out blue light, and a green color resistance that filters out green light. Specifically, for example, the first color resistance 41 is a red color resistance, the second color resistance 42 is a green color resistance, and the third color resistance 43 is a blue color resistance. As shown in FIG. 25, the brightness attenuation spectrum of green light emitted through the green color resistance 41 (the curve shown by -----G) is located between the brightness attenuation spectrum of red light emitted through the red color resistance (the curve shown by -R) and the brightness attenuation spectrum of blue light emitted through the blue color resistance (the curve shown by --B). In the embodiment of the present disclosure, the smaller the difference between the angular brightness attenuation trend of green light, the angular brightness attenuation trend of red light and the angular brightness attenuation trend of blue light, the smaller the angular color shift under white light. By adjusting the angular brightness attenuations of these three colors of light as those shown in FIG. 25, the brightnesses of different colors of light at viewing angles are re-matched, so as to achieve the purpose of improving the angular optical characteristics.

In one possible implementation, the light-emitting part 4 includes an organic light-emitting layer. Specifically, the light-emitting part 4 may include one or more of an anode, a hole injection layer, a hole transport layer, an organic light-emitting layer, an electron transport layer, an electron injection layer, and a cathode sequentially located on the base substrate 1.

In one possible implementation, as shown in FIG. 4, the display substrate further includes an encapsulation layer 6 between the pixel defining layer 2 and the black matrix 3, and a touch layer 7 between the encapsulation layer 6 and the black matrix 3. Specifically, the side of the color film layer 5 facing away from the pixel defining layer 2 can also be provided with a covering layer 81, and the side of the covering layer 81 facing away from the color film layer 5 can also be provided with an optical adhesive layer 82, and the side of the optical adhesive layer 82 facing away from the covering layer 81 can also be provided with a cover film 9. The covering layer 81 specifically can be an organic covering layer 81 for flattening the surface of the color film layer 5 facing away from the pixel defining layer 2. Specifically, the encapsulation layer 6 is a thin film encapsulation layer, and may include a first inorganic encapsulation layer, an organic encapsulation layer, and a second inorganic encapsulation layer.

Based on the same inventive concept, the embodiment of the present disclosure also provides a display device, including the display substrate provided by the embodiment of the present disclosure.

In the embodiment of the present disclosure, at the position of the pixel opening 20, in the same direction parallel to the base substrate 1, the opening expansion is inversely proportional to the length of the pixel opening orthographic projection 200. If the size of the pixel opening 20 is larger, the expanded amount of the first black matrix opening 31 with relative to the first pixel opening 21 is smaller, and if the size of the pixel opening 20 is smaller, the expanded amount of the first black matrix opening 31 with relative to the first pixel opening 21 is larger. Further, for the pixel openings with different light-emitting colors and different opening sizes, the brightness attenuation at the pixel openings with different light-emitting colors can be balanced to achieve a general balance, and the problems of color shift and deterioration of brightness attenuation of different colors at large viewing angles caused by inconsistent influence of black matrix openings (the smaller the pixel opening size, the greater the angular brightness attenuation) can be avoided.

Although the preferred embodiments of the present disclosure have been described, those skilled in the art can make additional changes and modifications to these embodiments once they know the basic inventive concepts. Therefore, the appended claims are intended to be interpreted as including the preferred embodiment and all changes and modifications that fall within the scope of the present disclosure.

Obviously, those skilled in the art can make various modifications and variations to the embodiments of the present disclosure without departing from the spirit and scope of the embodiments of the present disclosure. Thus, provided that these modifications and variations of the embodiments of the present disclosure are within the scope of the claims of the present disclosure and their equivalents, the present disclosure is also intended to include these modifications and variations.

**Claims**

1. A display substrate, comprising:

   a base substrate;
   a pixel defining layer, located at a side of the base substrate and having a plurality of pixel openings emitting light of different colors, wherein each of the plurality of pixel openings has a pixel opening orthographic projection on the base substrate; and
   a black matrix, located at a side of the pixel defining layer away from the base substrate and comprising black matrix openings corresponding to the pixel openings, wherein each of the black matrix openings has a black matrix opening orthographic projection on the base substrate, the black matrix opening orthographic projection covers the corresponding pixel opening orthographic projection, and the black matrix opening has an opening expansion with relative to the pixel opening; at positions of at least two pixel openings with different light-emitting colors, in a same direction parallel to the base substrate, the opening expansion is inversely proportional to a length of the pixel opening orthographic projection.

2. The display substrate according to claim 1, wherein the pixel opening orthographic projection is a polygon, and the pixel openings comprise a first pixel opening emitting light of a first color, the first pixel opening has a first side extending in a first direction, and a length of the first side of the first pixel opening is greater than or equal to lengths of remaining sides of the first pixel opening, and is greater than or equal to a longest side length of the pixel openings with other light-emitting colors;
   at the positions of the at least two pixel openings with different light-emitting colors, in a direction parallel to the base substrate and perpendicular to the first direction, the opening expansion is inversely proportional to the length of the pixel opening orthographic projection.

3. The display substrate according to claim 2, wherein at the positions of the at least two pixel openings with different light-emitting colors, in the first direction parallel to the base substrate, the opening expansion is inversely proportional to the length of the pixel opening orthographic projection.

4. The display substrate according to claim 2 or 3, wherein the first pixel opening is a red pixel opening emitting red light, and the pixel openings further comprise a blue pixel opening emitting blue light and a green pixel opening emitting green light;
   one blue pixel opening, one red pixel opening and one green pixel opening are sequentially arranged along a direction perpendicular to the first direction to constitute one repeating unit, and a plurality of repeating units are sequentially arranged along the direction perpendicular to the first direction to form a pixel opening row.

5. The display substrate according to claim 2 or 3, wherein the first pixel opening is a blue pixel opening emitting blue light, and the pixel openings further comprise a red pixel opening emitting red light and a green pixel opening emitting green light;
   one red pixel opening, one green pixel opening and one blue pixel opening constitute one repeating unit, and in the repeating unit, the red pixel opening and the green pixel opening are arranged along the first direction, and a straight line passing through a center of the blue pixel opening and perpendicular to the first direction is located at a gap between the red pixel opening and the green pixel opening; a plurality of repeating units are sequentially arranged along the direction perpendicular to the first direction to form a pixel opening row.

6. The display substrate according to claim 2 or 3, wherein the first pixel opening is a blue pixel opening emitting blue light, and the pixel openings further comprise a red pixel opening emitting red light, and a first green pixel opening and a second green pixel opening emitting green light;
   one red pixel opening, one first green pixel opening, one second green pixel opening and one blue pixel opening constitute one repeating unit, and in the repeating unit, a center of the red pixel opening, a center of the blue pixel opening, a center of the first green pixel opening and a center of the second green pixel opening form a quadrilateral, two sides of the quadrilateral are parallel to the first direction, and the other two sides are perpendicular to the first direction; a connecting line between the center of the red pixel opening and the center of the blue pixel opening forms a first diagonal line of the quadrilateral, and the repeating units are arranged in sequence along a direction parallel to the first diagonal line to form a pixel opening row.

7. The display substrate according to claim 1, wherein the pixel opening orthographic projection on the base substrate is circular, and the pixel openings comprise a blue pixel opening emitting blue light, a red pixel opening emitting red light, and a first green pixel opening and a second green pixel opening emitting green light;
one red pixel opening, one first green pixel opening, one second green pixel opening and one blue pixel opening constitute one repeating unit, and in the repeating unit, a center of the red pixel opening, a center of the blue pixel opening, a center of the first green pixel opening and a center of the second green pixel opening form a quadrilateral, and a connecting line between the center of the red pixel opening and the center of the blue pixel opening forms a first diagonal line of the quadrilateral, and the repeating units are arranged in sequence along a direction parallel to the first diagonal line to form a pixel opening row.

8. The display substrate according to any one of claims 1-7, wherein, in the same direction parallel to the base substrate, a ratio of opening expansions of at least two pixel openings with different light-emitting colors is approximately inversely proportional to a ratio of lengths of orthographic projections of the corresponding pixel openings with different light-emitting colors on the base substrate.

9. The display substrate according to any one of claims 1-8, wherein the opening expansion is in the range from 2 nm to 10 nm.

10. The display substrate according to any one of claims 1-9, wherein the display substrate further comprises a light-emitting part located at the pixel opening, and a color film layer located at a side of the black matrix away from the pixel defining layer; wherein the color film layer comprises a color resistance located at the black matrix opening; a peak wavelength of a transmission spectrum of the color resistance is blue-shifted with relative to a peak wavelength of an emission spectrum of the corresponding light-emitting part.

11. The display substrate according to claim 10, wherein the peak wavelength of the transmission spectrum of the color resistor is blue-shifted by 10 nm to 15 nm with relative to the peak wavelength of the emission spectrum of the corresponding light-emitting part.

12. The display substrate according to claim 10, wherein blue-shifted lengths of the peak wavelengths of the transmission spectrums of different color resistances with respect to the peak wavelengths of the emission spectrums of the corresponding light-emitting parts are substantially the same.

13. The display substrate according to claim 10, wherein the color resistance comprises a red color resistance for filtering out red light, a blue color resistance for filtering out blue light, and a green color resistance for filtering out green light; a brightness attenuation spectrum of green light emitted through the green color resistance is located between a brightness attenuation spectrum of red light emitted through the red color resistance and a brightness attenuation spectrum of blue light emitted through the blue color resistance.

14. The display substrate according to claim 10, wherein the light-emitting part comprises an organic light-emitting layer.

15. The display substrate according to any one of claims 1-14, wherein the display substrate further comprises an encapsulation layer between the pixel defining layer and the black matrix, and a touch layer between the encapsulation layer and the black matrix.

16. A display device, comprising the display substrate according to any one of claims 1-15.

FIG. 1

FIG. 2

EP 4 346 351 A1

| | Angular Color Shift/JNCD | | | Ratio of Angular Brightness Attenuations | | |
|---|---|---|---|---|---|---|
| | 30° | 45° | 60° | 30° | 45° | 60° |
| POL structure | 1.8 | 1.2 | 4.6 | 33% | 61% | 76% |
| Integrated COE structure | 3.4 | 5.6 | 8.4 | 40% | 74% | 88% |

FIG. 3

FIG. 4

FIG. 5

15

21(20/200)        23(20/200)        22(20/200)

31(30/300)        33(30/300)        32(30/300)

3

A

C ←→ D

B

a11        b11        c11

FIG. 6

21(20/200)        23(20/200)        22(20/200)

31(30/300)        33(30/300)        32(30/300)

3

A

C ←→ D

B

a13        b13        c13

FIG. 7

FIG. 8

FIG. 9

21(20/200)   22(20/200)   22(20/200)   Z

A
C     D
B

FIG. 10

21(20/200)                22(20/200)              23(20/200)
31(30/300)            32(30/300)              33(30/300)

3

A
C     D
B

a22  a21
a11

b22   b21
b11

c22   c21
c11

a12           b12              c12

FIG. 11

## angular brightness attenuation

—— R ⋯⋯ G —·— B

viewing angle (degrees)

FIG. 12

## CIE trajectory at Viewing Angle W

— -3 JNCD

— -4.5 JNCD

— -6 JNCD

—◆— CIE trajectory

FIG. 13

| Angular Color Shift/JNCD | | | Ratio of Angular Brightness Attenuations | | |
|---|---|---|---|---|---|
| 30° | 45° | 60° | 30° | 45° | 60° |
| 2 | 1.8 | 2 | 33% | 68% | 84% |

FIG. 14

FIG. 15

FIG. 16

FIG. 17

EP 4 346 351 A1

FIG. 18

FIG. 19

23

FIG. 20

FIG. 21

EP 4 346 351 A1

FIG. 22

FIG. 23

CF transmission spectrum vs EL spectrum_G

FIG. 24

angular brightness attenuation

FIG. 25

## INTERNATIONAL SEARCH REPORT

| | International application No. |
|---|---|
| | **PCT/CN2021/143117** |

**A. CLASSIFICATION OF SUBJECT MATTER**

H01L 27/32(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

DWPI, ENTXT, CNTXT, ENTXTC, CNKI, IEEE: display, device, substrate, open, area, pixel, black, matrix, 显示, 装置, 基板, 开口, 区域, 像素, 黑, 矩阵

**C. DOCUMENTS CONSIDERED TO BE RELEVANT**

| Category* | Citation of document, with indication, where appropriate, of the relevant passages | Relevant to claim No. |
|---|---|---|
| X | CN 112106204 A (BOE TECHNOLOGY GROUP CO., LTD.) 18 December 2020 (2020-12-18)<br> description, paragraphs [0044]-[0174], and figures 1-10 | 1-16 |
| X | CN 111739915 A (WUHAN TIANMA MICRO-ELECTRONICS CO., LTD.) 02 October 2020 (2020-10-02)<br> description, paragraphs [0034]-[0078], and figures 1-20 | 1-16 |
| A | KR 20110058407 A (SAMSUNG MOBILE DISPLAY CO., LTD.) 01 June 2011 (2011-06-01)<br> entire document | 1-16 |
| A | CN 111679490 A (XIAMEN TIANMA MICRO-ELECTRONICS CO., LTD.) 18 September 2020 (2020-09-18)<br> entire document | 1-16 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **24 August 2022** | **02 September 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

<div align="center">

**INTERNATIONAL SEARCH REPORT**
**Information on patent family members**

</div>

| International application No. |
|---|
| **PCT/CN2021/143117** |

| Patent document cited in search report | | | Publication date (day/month/year) | Patent family member(s) | | | Publication date (day/month/year) |
|---|---|---|---|---|---|---|---|
| CN | 112106204 | A | 18 December 2020 | WO | 2020199083 | A1 | 08 October 2020 |
| | | | | US | 2021233966 | A1 | 29 July 2021 |
| CN | 111739915 | A | 02 October 2020 | CN | 111739915 | B | 12 July 2022 |
| KR | 20110058407 | A | 01 June 2011 | US | 2011121301 | A1 | 26 May 2011 |
| | | | | KR | 101193184 | B1 | 19 October 2012 |
| CN | 111679490 | A | 18 September 2020 | | None | | |